# EUROPEAN PATENT SPECIFICATION

(11) **EP 4 272 266 B1**
(45) Date of publication and mention of the grant of the patent: **05.06.2024**
(21) Application number: 21839584.6
(22) Date of filing: 21.12.2021
(51) Int. Cl.: H01L 33/50, F21K 9/232

(54) **LED FILAMENT**
LED-FILAMENT
FILAMENT LED

(30) Priority: 04.01.2021 EP 21150037
(43) Date of publication of application: 08.11.2023
(73) Proprietor: Signify Holding B.V., 5656 AE Eindhoven (NL)
(72) Inventor: VAN BOMMEL, Ties, 5656 AE Eindhoven (NL); HIKMET, Rifat, Ata, Mustafa, 5656 AE Eindhoven (NL)
(74) Representative: Verweij, Petronella Daniëlle
(86) International application number: PCT/EP2021/087120
(87) International publication number: WO 2022/144252

(56) References cited:
- EP-A1- 3 438 519
- EP-A2- 2 292 970
- WO-A1-2020/120438
- CN-A- 105 805 601
- TW-A- 201 535 804
- US-A- 5 726 535
- US-A1- 2014 104 829
- US-A1- 2014 197 440
- US-A1- 2019 376 650
- US-A1- 2020 158 300

## Description

### FIELD OF THE INVENTION

The present invention generally relates to lighting arrangements comprising one or more light emitting diodes, LEDs. More specifically, the lighting arrangement is related to a light emitting diode, LED, filament. The present invention is further related to a lighting device comprising a LED filament.

### BACKGROUND OF THE INVENTION

The use of light emitting diodes, LEDs, for illumination purposes continues to attract attention. Compared to incandescent lamps, fluorescent lamps, neon tube lamps, etc., LEDs provide numerous advantages such as a longer operational life, a reduced power consumption, and an increased efficiency related to the ratio between light energy and heat energy.

There is currently a very large interest in lighting devices and/or arrangements (such as lamps) provided with LEDs, and incandescent lamps are rapidly being replaced by LED-based lighting solutions. It is nevertheless appreciated and desired to have retrofit lighting devices (e.g. lamps) which have the look of an incandescent bulb. For this purpose, it is possible to make use of the infrastructure for producing incandescent lamps based on LED filaments arranged in such a bulb. It will be appreciated that LED filament lamps of this kind are highly appreciated as they are very decorative. A LED filament according to the state of the art is disclosed in document EP 2292970 A2.

However, it is of interest to improve one or more properties of the LED filaments. In particular, there is a wish to improve the appearance of the LED filaments, to reduce the production cost of the LED filaments and/or to provide a facilitated assembly of the LED filaments.

Hence, it is an object of the present invention to improve one or more properties of the LED filaments, and in particular to augment the aesthetical appearance and/or the decorative aspect of the LED filaments and/or the LED filament lamps.

### SUMMARY OF THE INVENTION

Hence, it is of interest to explore the possibility of combining one or more of the numerous advantages of LED filament arrangements comprising LEDs, whilst improving the appearance and/or the decorative aspect of the LED filaments and/or the LED filament lamps.

This and other objects are achieved by providing a LED filament having the features in the independent claim. Preferred embodiments are defined in the dependent claims.

Hence, according to the present invention, there is provided a light emitting diode, LED, filament, comprising a plurality of light emitting diodes LEDs, wherein the LED filament comprises a center axis, A, and elongates in a meandering shape in a first plane, P. The LED filament further comprises a first portion which elongates along the center axis, A, comprising an array of the plurality of LEDs and an encapsulant at least partially enclosing the array of the plurality of LEDs. Furthermore, the LED filament comprises a second portion which elongates along the center axis, A, comprising a distribution of LEDs of the plurality of LEDs. Moreover, the first portion and the second portion of the LED filament are arranged on opposite sides with respect to the first plane, P.

Thus, the present invention is based on the idea of providing a flat meandering shaped LED filament which to an observer may be analogous in appearance to a spiral-shaped or coil-shaped LED filament. The LED filament is enabled to provide different types or modes of light emission, more particularly a direct lighting mode and an indirect lighting mode. Hence, the purpose of the features of the LED filament of the present invention is to mimic the appearance of a LED filament having a spiral or coil shape. An object of the present invention is therefore to utilize the aforementioned lighting modes in combination to generate a variety of lighting effects all the while presenting an appearance resembling a spiral-shaped or coil-shaped LED filament. The present invention is advantageous in that the numerous advantages of using LED technology may be combined with the attractiveness and the appealing properties of the LED filament as disclosed.

The present invention is further advantageous in that the different shapes of the first and second portions of the LED filament(s) contribute to the aesthetic attractiveness of the LED filament and/or the light emitted from the LED filament.

The present invention is further advantageous in that the LED filament comprises relatively few components. The low number of components is advantageous in that the LED filament is relatively inexpensive to fabricate. Moreover, the low number of components of the LED filament implies an easier recycling, especially compared to devices or arrangements comprising a relatively high number of components which impede an easy disassembling and/or recycling operation.

The LED filament of the present invention comprises an array of a plurality of LEDs disposed on the first portion and second portion forming the LED filament. By the term "array", it is here meant a linear arrangement or chain of LEDs, or the like, arranged on the LED filament.

The LED filament comprises a center axis, A, and the LED filament elongates in a meandering shape in a first plane, P. By "meandering shape", it is here meant that the shape of the LED filament or the direction of unfoldment of the LED filament proceeds in a convoluted fashion. In other words, the meandering-shaped LED filament is a LED filament which pattern follows a sinusoidal shape. Furthermore, by the term "shape" it is here meant the physical property of the LED filament such as e.g. the size, form and/or configuration of the LED filament. By the term "plane", it is here meant a flat surface. In other words, the LED filament embodies a sinusoidal pattern along the center axis, A, with substantially no deviation in a dimension perpendicular to the first plane, P. Therefore, the meandering shape of the LED filament encompasses only two dimensions, i.e. the ones forming the first plane, P, which renders the LED filament very compact and thin.

According to the present invention, the LED filament comprises a first portion of the LED filament, which elongates along the center axis, A. The first portion comprises an array of the plurality of LEDs and an encapsulant at least partially enclosing the array of the plurality of LEDs. The LED filament further comprises a second portion which elongates along the center axis, A, wherein the second portion comprises a distribution of LEDs of the plurality of LEDs. By the term "distribution", it is here meant an allocation, apportionment and/or concentration of LEDs on the second portion. The first portion and the second portion of the LED filament are arranged on opposite sides with respect to the first plane, P. Hence, the LED filament presents a first portion and a second portion representing opposite sides of the meandering-shaped LED filament with respect to the first plane, P. The first and second portions differ from one another in terms of the lighting effect provided by the respective arrays of LEDs mounted on each portion(s). The present invention is advantageous in that the first portion operates in a direct mode in which the LEDs disposed on the first portion emit light constituting the main emission of light in a main direction whereas the second portion operates in an indirect mode in which the LEDs distributed thereon emit additional light supplementing the light emitted by the LEDs of the first portion. By the term "main direction" it is here meant the desired direction towards which a lighting device comprising the LED filament is meant to distribute light. For example, the main direction of a LED filament of a luminaire positioned in a room may be oriented towards the center of the room. By the term "additional light" it is here meant supplementary light or background light emitted in a direction substantially opposite to the main direction of the light emitted by the LEDs disposed on the first portion. The combination of the LEDs of the first portion with the LEDs of the second portion therefore enables a greater variety of lighting effects achievable by the LED filament. This combination further allows the meandering-shaped LED filament to resemble the appearance of a spiral or coil-shaped LED filament. Moreover, the present invention is advantageous in that the encapsulant at least partially enclosing the array of LED mounted on the first portion provides additional protection to the LEDs of the LED filament increasing the longevity of the luminaire or lighting device in which the LED filament is used. By the term "encapsulant", it is here meant a material, element, arrangement, or the like, which is configured or arranged to at least partially surround, encapsulate and/or enclose the plurality of LEDs of the LED filament(s).

According to an embodiment of the present invention, at least one of a number of LEDs of the first portion, N₁, and a number of LEDs of the second portion, N₂, may fulfil N₁ > N₂, and a number of LEDs, dN₁, per unit length, dL₁, of the first portion, dN₁/dL₁, and a number of LEDs, dN₂, per unit length, dL₂, of the second portion, dN₂/dL₂ may fulfil dN₁/dL₁ > dN₂/dL₂. In other words, the first portion comprises a more condensed array of LEDs in contrast to the distribution of the second portion. Hence, the first portion has a higher density or concentration of LEDs per unit of length than the second portion. The present embodiment is consequent with the direct mode of operation of the first portion representing the main emission of light of the LED filament and with the indirect mode of operation of the second portion representing additional lighting. The present embodiment is therefore advantageous in that it enables a great variety of lighting effects through the differently LED-loaded first portion and second portion of the LED filament. It will be appreciated that the number of LEDs of the first portion, N₁, and the number of LEDs of the second portion, N₂, may preferably fulfil N₁>1.5N₂ and dN₁/dL₁>1.5 dN₂/dL₂, more preferably fulfil N₁>2N₂ and dN₁/dL₁>2 dN₂/dL₂ and most preferably fulfil N₁>2.5 N₂ and dN₁/dL₁>2.5 dN₂/dL₂.

According to an embodiment of the present invention, the distribution of LEDs of the second portion of the LED filament may comprise LEDs arranged equidistantly along the center axis, A. Hence, the LEDs may be arranged with a constant distance between each other along the center axis, A. For example, the LEDs comprised on the second portion may be arranged at every peak of the sinusoidal shape of the LED filament in the direction of its elongation. The equidistantly arranged LEDs may further be arranged at every cycle of the sinusoidal shape of the LED filament along the center axis A. The present embodiment is advantageous in that it enables a uniform light distribution from the second portion of the LED filament.

According to the present invention, the LED filament comprises an element arranged between the first portion and the second portion of the LED filament, wherein the element is at least partially opaque. Furthermore, according to the present invention, the element is configured to partially enclose the distribution of LEDs of the second portion of the LED filament. The present embodiment prevents the light emitted by the LEDs of the second portion operating in an indirect mode to pass through the element and into the direction of the light emitted by the LEDs of the first portion operating in a direct mode. The present embodiment therefore enables a better control over the light effect provided by the LED filament. Additionally, the present embodiment is advantageous in that it permits the covering of the LEDs of the second portion which are meant to emit background or additional light, but which structure should not be visible by a person looking directly at the LED filament in order to improve its aesthetic appearance.

According to an embodiment of the present invention, the element may comprise a carrier arranged to support the plurality of LEDs. Hence, the carrier is arranged to provide mechanical and/or electrical support to the plurality of LEDs. It will be appreciated that the carrier may be formed of a light transmissive material such that it does not hinder the transmission or distribution of the light emitted by the LEDs. It will be further embodied that the carrier may be formed of one or more rigid materials, e.g. glass, ceramic, sapphire, or formed of flexible materials e.g. polymer such as polyamide, etc. Moreover, the carrier may comprise electrodes for electrically connecting the at least one LED of the plurality of LEDs. The present embodiment is advantageous in that at least a portion of the light emitted by the LEDs of the LED filament may be transmitted through the carrier, thereby further contributing to the lighting properties and/or decorative appearance of the LED filament.

According to an embodiment of the present invention, the first portion of the LED filament may be configured to emit light with a first intensity, I₁, and a first color temperature, CT₁, and the second portion of the LED filament may be configured to emit light with a second intensity, I₂, and a second color temperature, CT₂, wherein at least one of I₁ ≠ I₂ and CT₁ ≠ CT₂ may be fulfilled. By the term "color temperature" it is here meant the temperature of an ideal black-body radiator that radiates light of a color comparable to that of the LEDs. For example, the light emitted from the first portion during operation of the LED filament may have a relatively high color temperature and intensity, whereas the light emitted from the second portion during operation of the LED filament may have a relatively low color temperature and intensity. The present embodiment is therefore advantageous in that the capacity of the first portion and second portion of the LED filament to emit light with specific and individual lighting properties (i.e. light intensity and color temperature) enables a greater variety of lighting effects achievable by the LED filament.

According to an embodiment of the present invention, the first color temperature may fulfill CT₁ < 2500 K, the first and second color temperatures may fulfill |(CT₁ - CT₂)| > 500 K, and the first and second light intensity may fulfil I₁ < I₂. It will be appreciated that preferably 1.2I₁ < I₂ is fulfilled and that more preferably 1.5I₁ < I₂ is fulfilled. It should be noted that many LED filament lamps are configured to emit a relatively low color temperature, which may be about 2200 K. However, in a space such as living room, or the like, it may be preferred to have a color temperature providing e.g. a flame look. Hence, it is desirable to be able to combine a first color temperature, CT₁, lower than (inferior to) 2500 K, more preferably lower than (inferior to) 2300 K and most preferably lower than (inferior to) 2200 K with a second color temperature, CT₂, greater than (superior to) 2700 K, more preferably greater than (superior to) 2900 K and most preferably greater than (superior to) 3000 K.. The present embodiment is therefore advantageous in that the difference between CT₁ and CT₂ is at least 300 K, in order to achieve a (visible) effect. Furthermore, in case the difference between CT₁ and CT₂ is less than 1000 K, i.e. |(CT₁ - CT₂)| < 1000 K, a too "cold" light may be avoided and/or avoiding that the contrast between CT₁ and CT₂ is too high. The difference between CT₁ and CT₂ further enables a desirable lighting contrast between the direct mode of operation of the first portion and the indirect mode of operation of the second portion. Additionally, the first portion of the LED filament having a higher density of LEDs per unit of length in contrast to the second portion enables the LEDs of the first portion to operate at a lower light intensity than the LEDs of the second portion. The present embodiment is therefore advantageous in that the greater number of LEDs operating at a lower intensity allows the first portion to avoid lighting defaults such as spottiness whereas such lighting defaults may be less important on the second portion as it is not visible through the element at least partially enclosing its light distribution.

According to an embodiment of the present invention, the encapsulant may comprise at least one of a light-scattering material and a luminescent material. Hence, the encapsulant may comprise a luminescent material configured to at least partly convert light emitted from the plurality of LEDs and/or a light-scattering material configured to scatter light emitted from the plurality of LEDs. By the term "luminescent material", it is here meant a material, composition and/or substance which is configured to emit light under external energy excitation. For example, the luminescent material may comprise a fluorescent material. This is advantageous in that the LED filament may provide a desired light distribution and/or a decorative effect.

According to an embodiment of the present invention, the encapsulant may comprise a luminescent material and the distribution of LEDs of the plurality of LEDs of the second portion of the LED filament may comprise red-green-blue, RGB, LEDs. For example, the distribution of LEDs of the plurality of LEDs of the second portion of the LED filament may comprise RGB packaged LEDs. By the term "RGB packaged LEDs" it is here meant a grouping of at least one red, at least one green and at least one blue LED operable with respectively variable light intensities and respectively variable color temperatures enabling different light effects. The present embodiment is advantageous in that the RGB (packaged) LEDs distributed on the second portion of the LED filament may enable variation of the color temperature and light intensity of the light emitted from said second portion(s) of the LED filament.

According to an embodiment of the present invention, there is provided a lighting device. The lighting device may comprise a LED filament according to any one of the preceding embodiments, and a cover comprising an at least partially light-transmissive material, wherein the cover at least partially encloses the LED filament. The lighting device may further comprise an electrical connection connected to the LED filament for a supply of power to the plurality of LEDs of the LED filament. For example, the electrical connection may be provided via a mechanical connection used for holding the LED filament in place in the lighting device.

According to an embodiment of the present invention, the cover of the lighting device may constitute a light output window arranged in a second plane, S, parallel to the first plane, P, wherein the first portion of the LED filament may face the light output window. Furthermore, according to another embodiment of the present invention, the light output window may be configured to diffuse the light emitted from the plurality of LEDs. The output window may preferably be formed of a transparent material such that the meandering shape of the LED filament is visible through the output window, thus increasing the aesthetic appeal of the lighting device. The present embodiment is further advantageous in that the light output window improves the distribution of the light emitted by the various portions of the LED filament. Moreover, the present embodiment is advantageous in that the light diffusing window provides protection to the LED filament resulting in greater longevity of the light device, e.g. luminaire, in which the LED filament is used.

According to an embodiment of the present invention, the lighting device may comprise a reflective surface facing the second portion of the LED filament, wherein the reflective surface may be configured to reflect the light emitted from the distribution of LEDs of the second portion out of the lighting device via the light output window. The present embodiment is advantageous in that it permits a greater distribution of the light emitted from the LEDs of the second portion and reduces the lighting defaults, e.g. spottiness, of the LEDs of the second portion. According to an embodiment of the present invention, the lighting device may comprise a control unit configured to separately control the plurality of LEDs of the first portion of the LED filament and the plurality of LEDs of the second portion of the LED filament. The present embodiment is advantageous in that it enables the user to control the lighting effect of the lighting device, such as the intensity and/or the color temperature of the light emitted from the plurality of LEDs of the first and second portions of the LED filament. It will be appreciated that the control unit may further be configured to individually control the LEDs of the first portion in relation to the LEDs of the second portion.

Further objectives of, features of, and advantages with, the present invention will become apparent when studying the following detailed disclosure, the drawings and the appended claims. Those skilled in the art will realize that different features of the present invention can be combined to create embodiments other than those described in the following.

### BRIEF DESCRIPTION OF THE DRAWINGS

This and other aspects of the present invention will now be described in more detail, with reference to the appended drawings showing embodiment(s) of the invention.
Fig. 1 shows a LED filament lamp according to the prior art,
Fig. 2a shows the first portion of a LED filament according to an exemplifying embodiment of the present invention,
Fig. 2b shows the second portion of a LED filament according to an exemplifying embodiment of the present invention,
Figs. 3a-3c show cross sections of the LED filament of according to exemplifying embodiments of the present invention, and
Figs. 4 show LED lighting device comprising the LED filament according to exemplifying embodiments of the present invention.

### DETAILED DESCRIPTION

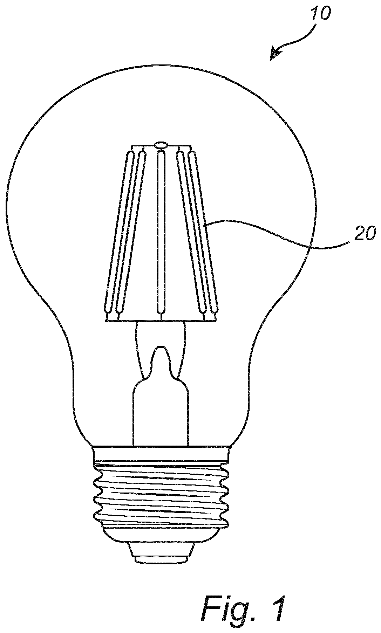

Fig. 1 shows a LED filament lamp 10 according to the prior art, comprising a plurality of LED filaments 20. LED filament lamps 10 of this kind are highly appreciated as they are very decorative, as well as providing numerous advantages compared to incandescent lamps such as a longer operational life, a reduced power consumption, and an increased efficiency related to the ratio between light energy and heat energy. LED filament lamps 10 of this kind are able to produce warm white light. However, it is of interest to improve the properties of the light emitted from the LED filaments 20 without impairing the appearance and/or the decorative aspect of the LED filaments 20 and/or the LED filament lamps 10.

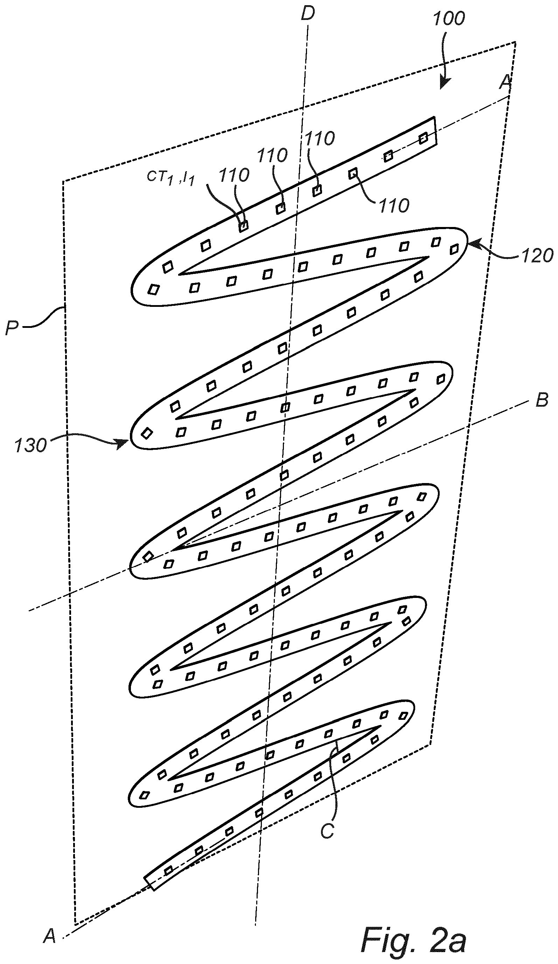

Fig. 2a illustrates a first portion 120 of a LED filament 100 according to an exemplifying embodiment of the present invention. The LED filament 100 is shown having a meandering shape or sinusoidal shape. The meandering-shaped LED filament 100 of Fig. 2a is shown elongating along a center axis, A, within a first plane, P, wherein the first plane, P, is a flat plane formed by a first axis, D, and a second axis, B, perpendicular to the first axis, D. The flat first plane, P, thus enables the LED filament 100 to be highly suitable for luminaire applications, which may require flatter light sources, whilst still having the aesthetic appearance of a spiral or coil-shaped filament. Moreover, Fig. 2a shows the meandering-shaped LED filament 100 comprising a relatively small radius of curvature, C, between its adjoining segments therefore forming relatively sharp corners. The sharp radius of curvature, C, depicted in Fig. 2a provides the optical illusion of a depth or perspective to the flat LED filament 100, which mimics a spiral-shaped or coil-shaped LED filament.

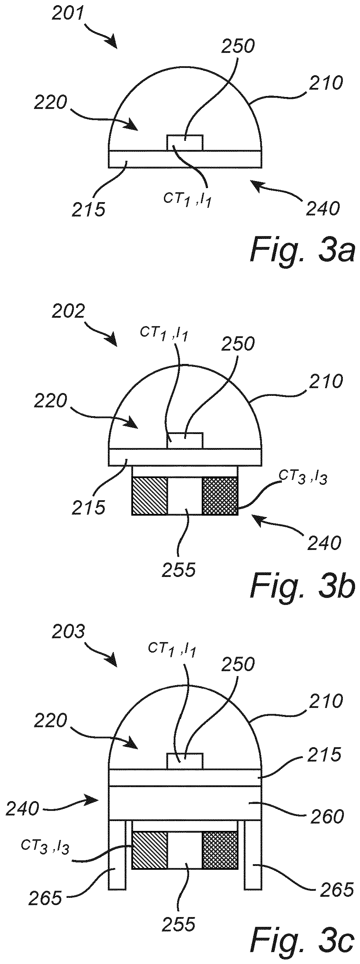

Fig. 2a further illustrates an array of a plurality of LEDs 110 mounted on a sinusoidal-shaped structure formed of an element (not shown in Fig. 2a but detailed later in Fig. 3a-3c) and a carrier 130. It will be appreciated that the element and the carrier 130 are also flat and comprised in the first plane, P. Furthermore, the array of the plurality of LEDs 110 disposed along the meandering-shaped LED filament 100 is shown configured to emit light according to a direct mode of operation, with the purpose to create a main lighting effect resembling a coil-shaped filament. Fig. 2a further illustrates the array of the plurality of LEDs 110 covering the entire surface of the first portion 120 of the LED filament 100.The first portion 120 of the LED filament 100 is arranged to comprise an encapsulant at least partially enclosing the array of the plurality of LEDs 110. However, for an increased understanding and/or visibility of the plurality of LEDs 110, the encapsulant is not shown in Fig. 2a.

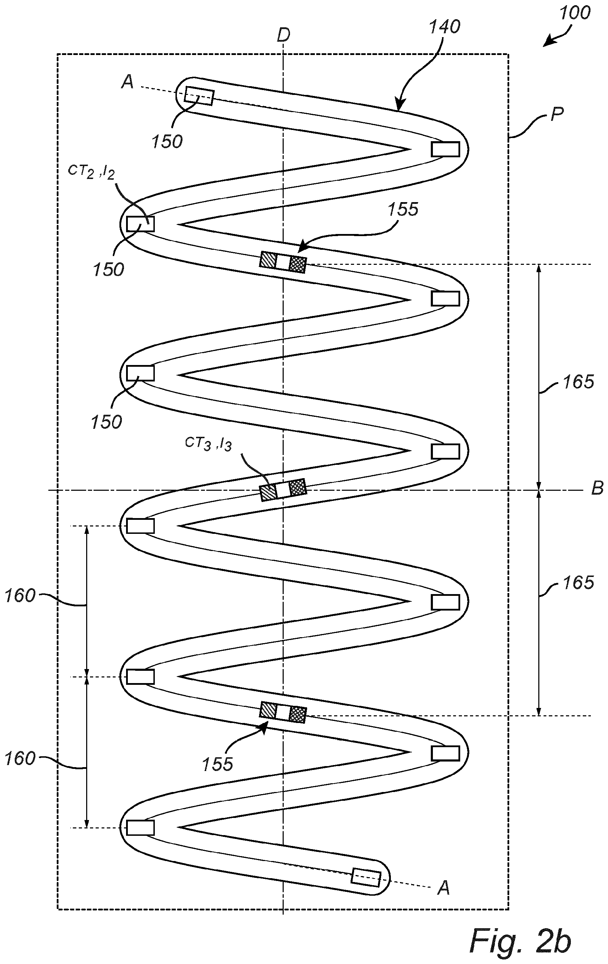

Fig. 2b illustrates a second portion 140 of the LED filament 100 according to an exemplifying embodiment of the present invention. It will be appreciated that the second portion 140 is arranged on the opposite side of the first portion 120 shown in Fig. 2a with respect the first plane, P. In other words, the first portion 120 of Fig. 2a represents one side of the LED filament 100 and the second portion 140 of Fig. 2b represents the opposite side of the LED filament 100. The second portion 140 of the LED filament 100 shown in Fig. 2b also elongates along the center axis, A, respecting the meandering shape of the LED filament 100 identically as the first portion 120 of Fig. 2a. Fig. 2b further illustrates a distribution of LEDs of the second portion 140, comprising a plurality of LEDs 150, 155 differently disposed along the length of the second portion 140. It will be appreciated that the distribution of LEDs 150 mounted on the second portion 140 may be RGB packaged LEDs enabling variation of their emitted light intensity and light color temperature. It will further be appreciated that the distribution of LEDs 150 mounted on the second portion 140 may be direct emitting LEDs, i.e. LEDs comprising no phosphor cover. Fig. 2b shows two types of LEDs, monochrome LEDs 150 and RGB packaged LEDs 155. The monochrome LEDs 150 are disposed on every peak of the sinusoidal shape of the LED filament 100 in the direction of its elongation. Moreover, Fig. 2b illustrates the monochromes LEDs 150 being equidistantly spaced by a first distance 160 along the first axis, D. Fig. 2b further shows the RGB packaged LEDs 155 disposed on the center of the meandering-shaped LED filament 100, wherein the LEDs 155 are also equidistantly spaced from one another by a second distance 165 along the first axis, D. It will be appreciated that the distances separating each LEDs of the respective groupings of LEDs 150, 155 may differ. In other words, the first distance 160 between the monochrome LEDs 150 may differ from the second distance 165 between the RGB packaged LEDs 155. In addition, the total number of LEDs 110 of the array of LEDs disposed along the elongation of the first portion 120 of the LED filament 100 shown in Fig. 2a is greater than the total number of LEDs, i.e. the combination of the monochrome LEDs 150 and the RGB packaged LEDs 155, of the distribution of LEDs disposed on the second portion 140 of the LED filament 100 shown in Fig. 2b. Consequently, the density of LEDs 110 per unit of length of the first portion 120 shown in Fig. 2a is greater than the density of LEDs 150, 155 per unit of length of the second portion 140 shown in Fig. 2b. It will be appreciated that the color temperature, CT₁, and the light intensity, I₁, of the light emitted by the LEDs 110 disposed on the first portion 120 of the LED 100 filament shown in Fig. 2a differ from the color temperature, CT₂, CT₃, and the light intensity, I₂, I₃, of the light emitted by the monochrome LEDs 150 and the RGB packaged LEDs 155 respectively, disposed on the second portion 140 of the LED 100 filament shown in Fig. 2b. It will further be appreciated that the light intensity, I₁, of the LEDs 110 of the first portion 120 is lower than (inferior to) the light intensity, I₂, of the light emitted by the monochrome LEDs 150. Furthermore, the light intensity, I₁, of the LEDs 110 of the first portion 120 is lower than (inferior to) the light intensity, I₃, of the RGB packaged LEDs 155 of the second portion 140. Furthermore, the color temperature, CT₁, of the LEDs 110 of the first portion 120 is preferably lower than (inferior to) 2500K and at least differs from the color temperatures, CT₂, CT₃, of the LEDs 150, 155 of the second portion 140 by 500K. It will further be appreciated that, in Fig. 2b, the color temperature, CT₂, and intensity, I₂, of the monochrome LEDs 150 may also differ from the color temperature, CT₃, and light intensity, I₃, of the RGB packaged LEDs 155.

Fig. 3a illustrates a cross section 201 of a LED filament according to an exemplifying embodiment of the present invention. The cross section 201 shown in Fig. 3a represents a cross section of a segment of the LED filament for which only the first portion 220 thereof comprises an array of LEDs 250 disposed on its structure. The LEDs 250 are arranged to emit light with a first intensity, I₁, and with a first color temperature, CT₁. Fig. 3a further illustrates an encapsulant 210 at least partially enclosing the array of LEDs 250 of the first portion 220. It will be appreciated that the encapsulant 210 acts as a filling material surrounding the LED filament and is formed of at least one of a light-scattering material and a luminescent material. It will further be appreciated that the thickness of the encapsulant 210 may vary along the elongation of the meandering-shaped LED filament. Fig. 3a further depicts the LEDs 250 mounted and supported in the center of a carrier 215. It is to be noted that the LEDs 250 may also be mounted off-centered on the carrier 215. The carrier 215 shown in Fig. 3a comprises a flat structure of minimal thickness and may be formed of a rigid or flexible material.

Fig. 3b illustrates a cross section 202 of the LED filament according to an exemplifying embodiment of the present invention. The cross section 202 shown in Fig. 3b represents a cross section of a segment of the LED filament for which the first portion 220 and the second portion 240 are shown comprising an array of monochrome LEDs 250 and a distribution of RGB packaged LEDs 255 respectively. The monochrome LEDs 250 are arranged to emit light with a first intensity, I₁, and with a first color temperature, CT₁, whereas the RGB packaged LEDs 255 are arranged to emit light with a third intensity, I₃, and with a third color temperature, CT₃. Furthermore, Fig. 3b shows the carrier 215 supporting both the monochrome LEDs 250 of the first portion 220 and the RGB packaged LEDs 255 distributed on the opposing second portion 240. Similarly to Fig. 3a, the monochrome LEDs 250 of the first portion 220 are shown in Fig. 3b enclosed by the encapsulant 210. It is to be noted that the RGB packaged LEDs 255 distributed on the second portion 240 may be at least partially enclosed by an encapsulant (not shown). In such case, the encapsulant at least partially enclosing the RGB packaged LEDs 255 comprises no luminescent material.

Fig. 3c illustrates a cross section 203 of the LED filament according to the present invention. The cross section 203 shown in Fig. 3c also represents a cross section of a segment of the LED filament for which the first portion 220 and the second portion 240 are shown comprising an array of monochrome LEDs 250 and a distribution of RGB packaged LEDs 255 respectively as well as comprising an element 260. The element 260 shown in Fig. 3b is positioned between the first portion 220 and the second portion 240 of the LED filament and is formed of a material at least partially opaque such that the light emitted from the RGB packaged LEDs 255 disposed on the second portion 240 do on infringe in the direction of light emission of the monochrome LEDs 250 disposed on the first portion 220. Furthermore, Fig. 3c depicts the element 260 comprising side sections 265 arranged on each side of the RGB packaged LEDs 255 of the second portion 240. The side sections 265 are shown in Fig. 3c at least partially enclosing the RGB packaged LEDs 255 such that their direction of light emission is limited and such that said RGB packaged LEDs 255 are not visible when the LED filament is oriented in a specific way with respect to an observer.

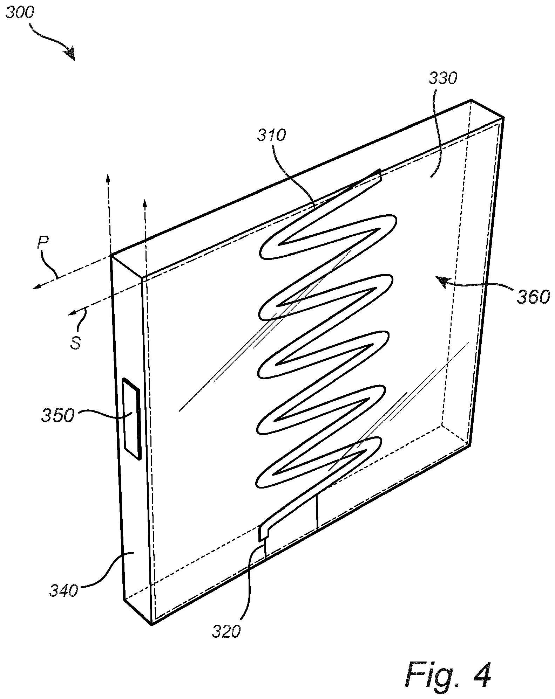

Fig. 4 illustrates a LED lighting device 300, e.g. a luminaire, comprising the LED filament according to any embodiment of the previous figure(s) and associated text(s). Fig. 4 shows a LED filament 310 mounted on a frame 340 such that the LED filament 310 elongates in a meandering shape in the first plane, P. Moreover, the lighting device 300 is shown comprising an electrical connection 320 connected to the LED filament 310 for supplying power to the plurality of LEDs of the LED filament 310. The lighting device 300 of Fig. 4 further comprises a cover or light output window 330, formed of a material at least partially light transmissive, mounted on the frame 340 and over the LED filament 310 such that the first portion of the LED filament 310 faces the light output window 330 and such that the light output window 330 diffuses the light emitted from the plurality of LEDs of the LED filament 310. Fig. 4 further depicts the light output window 330 comprised in a second plane, S, in turn shown parallel to the first plane, P, of the LED filament 310. Additionally, Fig. 4 illustrates a reflective surface 360 mounted on the backboard of the frame 340 and facing the second portion of the LED filament 310. It will be appreciated that the reflective surface 360 may also be integrally formed with/by the backboard of the frame 340. The reflective surface 360 shown in Fig. 4 is configured to reflect the light emitted from the distribution of LEDs of the second portion of the LED filament 310 out of the lighting device 300 via the light output window 330. Fig. 4 further depicts a schematically indicated control unit 350 mounted on the side of the frame 340. The control unit 350 is configured to separately control the plurality of LEDs of the first portion and the plurality of LEDs of the second portion of the LED filament 310. It will further be appreciated that the control unit 350 alternatively may be mounted on a wall close to the lighting device 300.

The person skilled in the art realizes that the present invention by no means is limited to the preferred embodiments described above. On the contrary, many modifications and variations are possible within the scope of the appended claims. For example, one or more of the LED filament(s) 100, the first portion 120 and/or the second portion 140 of the LED filament 100, etc., may have different shapes, dimensions and/or sizes than those depicted/described.

## Claims

1. A light emitting diode, LED, filament (100, 310), comprising
a plurality of light emitting diodes (110, 150, 155, 250, 255), LEDs, wherein the LED filament comprises a center axis, A, and elongates in a meandering shape in a first plane, P, wherein
a first portion (120, 220) of the LED filament, which elongates along the center axis, A, comprises an array of the plurality of LEDs and an encapsulant (210) at least partially enclosing the array of the plurality of LEDs, and
a second portion (140, 240) of the LED filament, which elongates along the center axis, A, comprises a distribution of LEDs (150, 155) of the plurality of LEDs, and
wherein the first portion and the second portion of the LED filament are arranged on opposite sides with respect to the first plane, P,
wherein the LED filament further comprises an element (260) arranged between the first portion and the second portion of the LED filament, wherein the element is at least partially opaque, and
**characterized in that**
the element is configured to partially enclose the distribution of LEDs of the second portion of the LED filament.

2. The LED filament according to claim 1, wherein at least one of
a number of LEDs of the first portion, N₁, and a number of LEDs of the second portion, N₂, wherein N₁ > N₂, and
a number of LEDs, dN₁, per unit length, dL₁, of the first portion, dN₁/dL₁, and a number of LEDs, dN₂, per unit length, dL₂, of the second portion, dN₂/dL₂, wherein dN₁/dL₁ > dN₂/dL₂,
is fulfilled.

3. The LED filament according to any one of the preceding claims, wherein the distribution of LEDs of the second portion of the LED filament comprises LEDs arranged equidistantly along the center axis, A.

4. The LED filament according to any one of the preceding claims, wherein the element comprises a carrier (130, 215) arranged to support the plurality of LEDs.

5. The LED filament according to any one of the preceding claims, wherein
the first portion of the LED filament is configured to emit light with a first intensity, I₁, and a first color temperature, CT₁, and
the second portion of the LED filament is configured to emit light with a second intensity, I₂, and a second color temperature, CT₂, and
wherein at least one of I₁ ≠ I₂ and CT₁ ≠ CT₂ is fulfilled.

6. The LED filament according to claim 5, wherein the first color temperature fulfills CT₁ < 2500 K, wherein the first and second color temperatures fulfill |(CT₁ - CT₂)| > 500 K, and wherein I₁ < I₂.

7. The LED filament according to any one of the preceding claims, wherein the encapsulant comprises at least one of a light-scattering material and a luminescent material.

8. The LED filament according to claim 7, wherein the encapsulant comprises a luminescent material and wherein the distribution of LEDs of the plurality of LEDs of the second portion of the LED filament comprises red-green-blue, RGB, LEDs.

9. A lighting device (300), comprising
a LED filament (310) according to any one of the preceding claims,
a cover (330) comprising an at least partially light-transmissive material,
wherein the cover at least partially encloses the LED filament, and
an electrical connection (320) connected to the LED filament for a supply of power to the plurality of LEDs of the LED filament.

10. The lighting device according to claim 9, wherein the cover constitutes a light output window (330) arranged in a second plane, S, parallel to the first plane, P, and wherein the first portion of the LED filament faces the light output window.

11. The lighting device according to claim 10, wherein the light output window is configured to diffuse the light emitted from the plurality of LEDs.

12. The lighting device according to claim 10 or 11, further comprising a reflective surface (360) facing the second portion of the LED filament, wherein the reflective surface is configured to reflect the light emitted from the distribution of LEDs of the second portion out of the lighting device via the light output window.

13. The lighting device according to any one of claims 10-12, further comprising a control unit (350) configured to separately control the plurality of LEDs of the first portion of the LED filament and the plurality of LEDs of the second portion of the LED filament.

## Patentansprüche

1. Filament einer lichtemittierenden Diode, LED-Filament, (100, 310), umfassend
eine Vielzahl von lichtemittierenden Dioden (110, 150, 155, 250, 255), LEDs, wobei das LED-Filament eine Mittelachse, A, umfasst und sich in einer mäandernden Form in einer ersten Ebene, P, verlängert, wobei
ein erster Abschnitt (120, 220) des LED-Filaments, der sich entlang der Mittelachse, A, verlängert, eine Anordnung der Vielzahl von LEDs und ein Verkapselungsmittel (210), das die Anordnung der Vielzahl von LEDs mindestens teilweise umschließt, umfasst und
ein zweiter Abschnitt (140, 240) des LED-Filaments, der sich entlang der Mittelachse, A, verlängert, eine Verteilung von LEDs (150, 155) der Vielzahl von LEDs umfasst und
wobei der erste Abschnitt und der zweite Abschnitt des LED-Filaments an gegenüberliegenden Seiten in Bezug auf die erste Ebene, P, eingerichtet sind,
wobei das LED-Filament ferner ein Element (260), das zwischen dem ersten Abschnitt und dem zweiten Abschnitt des LED-Filaments eingerichtet ist, umfasst, wobei das Element mindestens teilweise undurchsichtig ist und
**dadurch gekennzeichnet, dass** das Element konfiguriert ist, um die Verteilung von LEDs des zweiten Abschnitts des LED-Filaments teilweise zu umschließen.

2. LED-Filament nach Anspruch 1, wobei mindestens eines von
eine Anzahl von LEDs des ersten Abschnitts, N₁, und eine Anzahl von LEDs des zweiten Abschnitts, N₂, wobei N₁ > N₂, und
eine Anzahl von LEDs, dN₁, pro Längeneinheit, dL₁, des ersten Abschnitts, dN₁/dL₁, und eine Anzahl von LEDs, dN₂, pro Längeneinheit, dL₂, des zweiten Abschnitts, dN₂/dL₂, wobei dN₁/dL₁ > dN₂/dL₂,
erfüllt ist.

3. LED-Filament nach einem der vorstehenden Ansprüche, wobei die Verteilung von LEDs des zweiten Abschnitts des LED-Filaments LEDs, die entlang der Mittelachse, A, äquidistant eingerichtet sind, umfasst.

4. LED-Filament nach einem der vorstehenden Ansprüche, wobei das Element einen Träger (130, 215) umfasst, der eingerichtet ist, um die Vielzahl von LEDs zu stützen.

5. LED-Filament nach einem der vorstehenden Ansprüche, wobei
der erste Abschnitt des LED-Filaments konfiguriert ist, um Licht mit einer ersten Intensität, I₁, und einer ersten Farbtemperatur, CT₁, zu emittieren, und
der zweite Abschnitt des LED-Filaments konfiguriert ist, um Licht mit einer zweiten Intensität, I₂, und einer zweiten Farbtemperatur, CT₂, zu emittieren, und
wobei mindestens eines von I₁ ≠ I₂ und CT₁ ≠ CT₂ erfüllt ist.

6. LED-Filament nach Anspruch 5, wobei die erste Farbtemperatur CT₁ < 2500 K erfüllt, wobei die erste und die zweite Farbtemperatur |(CT₁ - CT₂)| > 500 K erfüllen und wobei I₁ < I₂.

7. LED-Filament nach einem der vorstehenden Ansprüche, wobei das Verkapselungsmittel mindestens eines von einem lichtstreuenden Material und einem lumineszierenden Material umfasst.

8. LED-Filament nach Anspruch 7, wobei das Verkapselungsmittel ein lumineszierendes Material umfasst und wobei die Verteilung von LEDs der Vielzahl von LEDs des zweiten Abschnitts des LED-Filaments rot-grün-blaue, RGB, LEDs umfasst.

9. Beleuchtungsvorrichtung (300), umfassend
ein LED-Filament (310) nach einem der vorstehenden Ansprüche,
eine Abdeckung (330), umfassend ein mindestens teilweise lichtdurchlässiges Material, wobei die Abdeckung das LED-Filament mindestens teilweise umschließt, und
eine elektrische Verbindung (320), die mit dem LED-Filament für eine Stromversorgung der Vielzahl von LEDs des LED-Filaments verbunden ist.

10. Beleuchtungsvorrichtung nach Anspruch 9, wobei die Abdeckung ein Lichtabgabefenster (330), das in einer zweiten Ebene, S, parallel zu der ersten Ebene, P, eingerichtet ist, bildet und wobei der erste Abschnitt des LED-Filaments dem Lichtabgabefenster zugewandt ist.

11. Beleuchtungsvorrichtung nach Anspruch 10, wobei das Lichtabgabefenster konfiguriert ist, um das Licht, das von der Vielzahl von LEDs emittiert wird, zu diffundieren.

12. Beleuchtungsvorrichtung nach Anspruch 10 oder 11, ferner umfassend eine reflektierende Oberfläche (360), die dem zweiten Abschnitt des LED-Filaments zugewandt ist, wobei die reflektierende Oberfläche konfiguriert ist, um das Licht, das von der Verteilung von LEDs des zweiten Abschnitts emittiert wird, über das Lichtabgabefenster aus der Beleuchtungsvorrichtung heraus zu reflektieren.

13. Beleuchtungsvorrichtung nach einem der Ansprüche 10 bis 12, ferner umfassend eine Steuereinheit (350), die konfiguriert ist, um die Vielzahl von LEDs des ersten Abschnitts des LED-Filaments und die Vielzahl von LEDs des zweiten Abschnitts des LED-Filaments separat zu steuern.

## Revendications

1. Filament à diodes électroluminescentes, DEL, (100, 310), comprenant
une pluralité de diodes électroluminescentes, DEL, (110, 150, 155, 250, 255) dans lequel le filament à DEL comprend un axe central, A, et s'allonge dans une forme sinueuse dans un premier plan, P, dans lequel
une première partie (120, 220) du filament à DEL, qui s'allonge le long de l'axe central, A, comprend un réseau de la pluralité de DEL et un agent d'encapsulation (210) enfermant au moins partiellement le réseau de la pluralité de DEL, et
une seconde partie (140, 240) du filament à DEL, qui s'allonge le long de l'axe central, A, comprend une distribution de DEL (150, 155) de la pluralité de DEL, et
dans lequel la première partie et la seconde partie du filament à DEL sont disposées sur des côtés opposés par rapport au premier plan, P,
dans lequel le filament à DEL comprend en outre un élément (260) disposé entre la première partie et la seconde partie du filament à DEL, dans lequel l'élément est au moins partiellement opaque, et
**caractérisé en ce que** l'élément est conçu pour enfermer partiellement la distribution de DEL de la seconde partie du filament à DEL.

2. Filament à DEL selon la revendication 1, dans lequel au moins l'un parmi
un nombre de DEL de la première partie, N₁, et un nombre de DEL de la seconde partie, N₂, dans lequel N₁ > N₂, et
un nombre de DEL, dN₁, par unité de longueur, dL₁, de la première partie, dN₁/dL₁, et un nombre de DEL, dN₂, par unité de longueur, dL₂, de la seconde partie, dN₂/dL₂, dans lequel dN₁/dL₁ > dN₂/dL₂,
est satisfait.

3. Filament à DEL selon l'une quelconque des revendications précédentes, dans lequel la distribution de DEL de la seconde partie du filament à DEL comprend des DEL disposées de manière équidistante le long de l'axe central, A.

4. Filament à DEL selon l'une quelconque des revendications précédentes, dans lequel l'élément comprend un support (130, 215) disposé pour soutenir la pluralité de DEL.

5. Filament à DEL selon l'une quelconque des revendications précédentes, dans lequel
la première partie du filament à DEL est configurée pour émettre de la lumière avec une première intensité, I₁, et une première température de couleur, CT₁, et
la seconde partie du filament à DEL est configurée pour émettre de la lumière avec une seconde intensité, I₂, et une seconde température de couleur, CT₂, et
dans lequel au moins l'un parmi I₁ ≠ I₂ et CT₁ ≠ CT₂ est satisfait.

6. Filament à DEL selon la revendication 5, dans lequel la première température de couleur satisfait à CT₁ < 2 500 K, dans lequel les première et seconde températures de couleur satisfont à |(CT₁ - CT₂)| > 500 K, et dans lequel I₁ < I₂.

7. Filament à DEL selon l'une quelconque des revendications précédentes, dans lequel l'agent d'encapsulation comprend au moins l'un parmi un matériau diffusant la lumière et un matériau luminescent.

8. Filament à DEL selon la revendication 7, dans lequel l'agent d'encapsulation comprend un matériau luminescent et dans lequel la distribution de DEL de la pluralité de DEL de la seconde partie du filament à DEL comprend des DEL rouge-vert-bleu, RVB.

9. Dispositif d'éclairage (300), comprenant
un filament à DEL (310) selon l'une quelconque des revendications précédentes,
un revêtement (330) comprenant un matériau transmettant au moins partiellement la lumière, dans lequel le revêtement enferme au moins partiellement le filament à DEL, et
une connexion électrique (320) connectée au filament à DEL pour une alimentation électrique de la pluralité de DEL du filament à DEL.

10. Dispositif d'éclairage selon la revendication 9, dans lequel le revêtement constitue une fenêtre de sortie lumineuse (330) disposée dans un second plan, S, parallèle au premier plan, P, et dans lequel la première partie du filament à DEL fait face à la fenêtre de sortie lumineuse.

11. Dispositif d'éclairage selon la revendication 10, dans lequel la fenêtre de sortie lumineuse est configurée pour diffuser la lumière émise à partir de la pluralité de DEL.

12. Dispositif d'éclairage selon la revendication 10 ou 11, comprenant en outre une surface réfléchissante (360) faisant face à la seconde partie du filament à DEL, dans lequel la surface réfléchissante est configurée pour réfléchir la lumière émise à partir de la distribution de DEL de la seconde partie hors du dispositif d'éclairage par l'intermédiaire de la fenêtre de sortie lumineuse.

13. Dispositif d'éclairage selon l'une quelconque des revendications 10 à 12, comprenant en outre une unité de commande (350) configurée pour commander séparément la pluralité de DEL de la première partie du filament à DEL et la pluralité de DEL de la seconde partie du filament à DEL.
